# EUROPEAN PATENT APPLICATION

(11) **EP 1 813 655 A1**
(43) Date of publication of application: **01.08.2007**
(21) Application number: 05793074.5
(22) Date of filing: 11.10.2005
(51) Int. Cl.: C09D 183/04, B05D 7/24, C01B 33/12, C09D 5/25, C09D 7/14, C09D 183/02, H01L 21/312, H01L 21/316, H01L 21/768

(54) **COATING LIQUID FOR FORMING LOW DIELECTRIC CONSTANT AMORPHOUS SILICA COATING FILM, METHOD FOR PREPARING SAME, AND LOW DIELECTRIC CONSTANT AMORPHOUS SILICA COATING FILM OBTAINED FROM SAME**

(30) Priority: 20.10.2004 JP 2004305661
(71) Applicant: CATALYSTS & CHEMICALS INDUSTRIES CO., LTD., Kawasaki-shi, Kanagawa 212-0013 (JP)
(72) Inventor: ARAO, Hiroki, Catalysts & Chemicals Ind.Co.Ltd, Kitakyushu-shi, Fukuoka 8080027 (JP); EGAMI, Miki, Catalysts & Chemicals Ind.Co.Ltd, Kitakyushu-shi, Fukuoka 8080027 (JP); NAKASHIMA, Akira, Catalysts & Chemicals Ind.Co.Ltd, Kitakyushu-shi, Fukuoka 8080027 (JP); KOMATSU, Michio, Catalysts & Chemicals Ind.Co.Ltd, Kitakyushu-shi, Fukuoka 8080027 (JP)
(74) Representative: HOFFMANN EITLE
(86) International application number: PCT/JP2005/018667
(87) International publication number: WO 2006/043438

(57) **Abstract**

Disclosed is a coating liquid for forming an amorphous silica-based coating film having a low dielectric constant of 3.0 or below and low leakage current, and a method for preparing the coating liquid. The coating liquid is a liquid composition comprising (a) silicon compound obtained by hydrolyzing tetraalkyl orthosilicate (TAOS) and alkoxysilane (AS) in the presence of tetraalkyl ammonium hydroxide (TAAOH) and water, or a silicon compound obtained by hydrolyzing or partially hydrolyzing tetraalkyl orthosilicate (TAOS) in the presence of tetraalkyl ammonium hydroxide (TAAOH) and water, mixing the hydrolyzed or partially hydrolyzed product with alkoxysilane (AS) or a hydrolyzed or partially hydrolyzed product thereof, and hydrolyzing all or a portion of the mixture, (b) an organic solvent, and (c) water. The coating liquid is **characterized in that** a quantity of water contained in the liquid composition is in the range from 30 to 60% by weight.

## Description

### TECHNICAL FIELD

The present invention relates to a coating liquid for forming an amorphous silica-based coating film having a low dielectric constant of 3.0 or below and also leaking only a very low amount of the electric current, a method for preparing the coating liquid and a low dielectric constant amorphous silica-based coating film obtained by applying the coating liquid on a substrate.

### BACKGROUND TECHNOLOGY

Recently in association with the progress in the technology for information networking, there are the strong needs for more advanced and sophisticated functions of, lower power consumption in, and size and weight reduction of equipment for information communications, and to satisfy the needs, now it is required to develop semiconductor devices having a higher processing speed and realize a higher degree in circuit integration. Improvement in performance of semiconductor devices has been realized by miniaturization of circuit design, but now device circuits are designed with the dimensions at a submicron level, and the integration degree is higher as compared to that in the past, but the power consumption has disadvantageously increased because of increase in the wiring capacitance, and there occur such problems as wiring delay or cross talk, and therefore further improvement by miniaturization of a circuit design can not be expected. Especially, in a semiconductor device with multilayered wirings designed under a rule of 0.25 microns, a space between metal wires becomes narrower, and therefore impedance in the metal wiring due to electrostatic induction increases, and there are serious concerns about the possibility of delay in response speed and increase in power consumption. To overcome the problems as described above, it is required to minimize a dielectric constant of an interlayer insulating film between a semiconductor substrate and a metal wiring layer such as an aluminum wiring layer or a copper wiring layer or between the metal wiring layers.
The inter-layer insulating film for the purpose as described above is generally formed on a semiconductor substrate by the vapor growth method such as the CVD method (Chemical Vapor Deposition method) or the spin coat method.

However, in the silica-based coating film obtained by the most advanced technique relating to the CVD method (Refer to, for instance, Patent document 1), although the specific dielectric constant of 3.0 or below can be achieved, like in the coating method based on the conventional technology, there occurs the problem that a strength of a coating film becomes lower as the specific dielectric constant becomes lower. Furthermore, in a CVD coating film made of polyallyl resin, fluorine-added polyimide resin, or fluorine resin, or in a coating film formed with the coating liquid, the specific dielectric constant is around 2, but the adhesiveness to a surface of a substrate is low, and also the adhesiveness to a resist material used in microfabrication is also low. Furthermore the chemical resistance and oxygen plasma resistance are disadvantageously low.
Furthermore, with the coating film obtained by using a hydrolysate of alkoxysilane and/or halogenated silane or a coating liquid for forming a silica-based coating film containing the hydrolysate above, it is possible to obtain a coating film having a specific dielectric constant of 3.0 or below, but the adhesiveness, film strength, chemical resistance, cracking resistance, oxygen plasma resistance and other properties are disadvantageously low.

The present inventors devoted themselves to investigation for solving the problems as described above, and found that it is possible to form a coating film having a specific dielectric constant of 3.0 or below and excellent in such physical properties as the adhesiveness to a coated surface, film strength, chemical resistance such as alkali resistance, cracking resistance, and smoothness of a surface of a coating film and furthermore excellent in process adaptability such as oxygen plasma resistance and being etched by using a) a coating liquid for forming a low dielectric constant silica-based coating film containing polysiloxane which is a reaction product between alkoxysilane and/or halogenated silane or hydrolysates of the materials and silica particles (Refer to, for instance, Patent document 2), (b) a coating liquid for forming a low dielectric constant silica-based coating film containing alkoxysilane and/or halogenated silane or hydrolysates of the materials and easily decomposable resin (Refer to, for instance, Patent document 3), c) a coating liquid for forming a low dielectric constant silica-based coating film containing polysiloxane which is a reaction product between alkoxysilane and/or halogenated silane or hydrolysates of the materials and silica particles, and easily decomposable resin which decomposes or evaporates at a temperature of 500 °C or below (Refer to, for instance, Patent document 4), or d) a coating liquid for forming a low dielectric constant silica-based coating film containing alkoxysilane and/or halogenated silane or hydrolysates of the materials and an organic template material (Refer to, for instance, Patent document 5).
The present inventors repeated, however, experiments for forming a low dielectric constant silica-based coating film by using the coating liquids and the known coating film forming method (such as the spin coat method and other coating methods) on various types of semiconductor substrates, and found that, although it was possible to obtain coating films having the characteristics as described above, it is difficult to stably obtain coating films having a Young's modulus of 6.0 GPa or more which are recently required from semiconductor manufacturers.

On the other hand, researchers in US California University have proposed a method in which a zeolite coating film (silica zeolite coating film having the MFI crystal structure) is formed on a semiconductor substrate by using a coating liquid prepared by separating and removing particles having a relatively large diameter from zeolite particles obtained by hydrolyzing tetraethyl orthosilicate (TEOS) dissolved in ethyl alcohol in the presence of tetrapropyl ammonium hydroxide (TPAOH). However, although the zeolite coating film obtained by the method has a Young's modulus of 16 to 18 GPa, because of the high hygroscopic property, the coating film absorbs moisture from the atmospheric air with the specific dielectric constant acutely increasing (for instance from 2.3 to 3.9), which disadvantageously makes it difficult to use the coating film for practical use (Refer to Patent document 6 and Non-patent document 1).

To solve the problems as described above, the inventors devoted themselves to investigation, and found the availability of a coating method for forming a low dielectric amorphous silica-based coating film containing a silicon compound obtained by hydrolyzing (a) tetraalkyl orthosilicate (TAOS) and specific alkoxysilane (AS) in the presence of tetraalkyl ammonium hydroxide (TAAOH), and made a patent application for the method and the material (Refer to Patent document 7). Furthermore, in relation to the invention above, the present inventors found (1) a method in which a coating liquid containing the silicon compound is applied on a substrate, heated at the temperature in the range from 80 to 350 °C, and then cured at the temperature in the range from 350 to 450 °C to form a low dielectric constant amorphous silica-based coating film, and (2) a method in which a coating liquid containing the silicon compound is applied on a substrate, heated at the temperature in the range from 80 to 350 °C, and then cured by irradiating an electron beam to the coated film to form a low dielectric constant silica-based coating film. The inventors made patent applications for the methods (Refer to Patent document 8 and Patent document 9).

Recently, however, the semiconductor manufacturers investigate the possibility of further lowering a dielectric constant of an inter-layer insulating film to reduce a wiring capacitance which tends to increase in association with the tendency for a higher integration degree, and have the strong need for materials having characteristics of a low leakage current adapted to suppression of power consumption. The term of "leakage current" as used herein means a electric current leaking like water at a place of an electronic circuit where the current should not leak, and when the leakage current increases, power consumption becomes larger, and also the heat value increases, which may often give damages to an integrated circuit. To make further higher the integration degree in a semiconductor and improve the performance, it is generally recognized that it is indispensable to develop a technique for minimizing an amount of the leakage current.

Although the mechanism for generation of the leakage current has not been clarified completely, it is generally considered that the leakage current is generated due to, for instance, (a) moisture absorbed in an inter-layer insulating film, (b) pinholes, pores, cracks, killer pores generated in association with generation of pores in a coating film for lowering a specific dielectric constant of an inter-layer insulating film, (c) presence of a leak path caused by ions of impurities included in the inter-layer insulating film, and the like. Of the suspected causes as described above, the problem of the leakage current caused by
(a) absorption of moisture and (c) ions of impurities can be solved by providing hydrophobicity to a coating film to be formed or by using a material (a coating liquid for forming a low dielectric constant coating film) not including impurity ions, but to solve the problem of current leakage caused by film defects as described in (b) above, it is necessary to develop a technique for controlling a pore structure at the nano level such as making the pore diameter smaller or homogeneous distribution of the pores.

Patent document 1: JP 2000-349083 A
Patent document 2: JP 1997-315812 A.
Patent document 3: WO 00/018847 A
Patent document 4: WO 00/012640 A
Patent document 5: JP 2002-030249 A
Patent document 6: US 2000/060364 A
Patent document 7: JP 2004-149714 A
Patent document 8: JP 2004-153147 A
Patent document 9: Specification of JP Application No. 2004-141749
Non-patent document 1: Advanced Material 2001, 13, No. 19, October 2, Pages 1453-1466

### DISCLOSURE OF THE INVENTION

### Problems to be Solved by the Invention

According to the amorphous silica-based coating film developed by the present inventors or the method for forming a coating film by using the coating liquid (Refer to Patent documents 7, 8, and 9), it is possible to form a silica-based coating film like a nanocluster and having micropores with the diameter of 2 nm or below, and therefore it is possible to suppress an amount of the leakage current to a low level, but the present inventors made further intensive investigation and found that the amount of the leakage current can substantially be reduced by controlling composition (especially, a content of water) of the coating liquid, and made the present invention. Namely, an object of the present invention is to provide a coating liquid for forming an amorphous silica-based coating film having a specific dielectric constant of 3.0 or below and leaking a current little and a method of preparing the coating liquid, and also to provide a low dielectric constant amorphous silica-based coating film having the low leakage current characteristics obtained by applying the coating liquid on a substrate.

### Means for Solving the Problems

A first coating liquid according to the present invention is used for forming an amorphous silica-based coating film having a low specific dielectric constant and a low leakage current, and the coating liquid comprises:
(a) a silicon compound obtained by hydrolyzing tetraalkyl orthosilicate (TAOS) and alkoxysilane (AS) expressed by the following general formula (I) in the presence of tetraalkyl ammonium hydroxide (TAAOH) and water,

   XₙSi(OR)₄₋ₙ (I)

   (wherein X denotes a hydrogen atom, a fluorine atom, an alkyl group having 1 to 8 carbon atoms, a fluorine-substituted alkyl group, an aryl group, or a vinyl group; and R denotes a hydrogen atom, an alkyl group having 1 to 8 carbon atoms, an aryl group, or a vinyl group; and n is an integer from 1 to 3);
(b) an organic solvent; and
(c) water
wherein an amount of water contained in the liquid composition is in the range from 30 to 60% by weight.

A second coating liquid according to the present invention is used for forming an amorphous silica-based coating film having a low specific dielectric constant and a low leakage current, and the coating liquid comprises:
(a) a silicon compound obtained by hydrolyzing or partially hydrolyzing tetraalkyl orthosilicate (TAOS) in the presence of tetraalkyl ammonium hydroxide (TAAOH) and water, mixing the hydrolyzed or partially hydrolyzed product with alkoxysilane (AS) expressed by the general formula (I) above or a hydrolyzed or partially hydrolyzed product thereof, and hydrolyzing all or a portion of the resultant mixture;
(b) organic solvent; and
(c) water,
wherein an amount of water contained in the liquid composition is in the range from 30 to 60% by weight.

In the coating liquids described above, the tetraalkyl orthosilicate (TAOS) is preferably tetraethyl orthosilicate (TEOS), tetramethyl orthosilicate (TMOS), or a mixture thereof, and the alkoxysilane (AS) is preferably methyl trimethoxysilane (MTMS), methyl triethoxysilane (MTES), or a mixture thereof, and the tetraalkyl ammonium hydroxide (TAAOH) is preferably tetrapropyl ammonium hydroxide (TPAOH), tetrabutyl ammonium hydroxide (TBAOH), or a mixture thereof.
The organic solvent is preferably selected from the group consisting of propylene glycol monopropyl ether (PGP), propylene glycol monomethyl ether (PGME), and propylene glycol monomethyl ether acetate (PGMEA).
Furthermore, the content of the silicon compound is preferably in the range from 2 to 20% by weight against the liquid composition.

A method for preparing the first coating liquid for forming a low dielectric constant amorphous silica-based coating film according to the present invention is employed for preparing a coating liquid for forming an amorphous silica-based coating film having a low specific dielectric constant and a low leakage current, and the method comprises the steps of:
(a) preparing a liquid composition containing a silicon compound obtained by hydrolyzing tetraalkyl orthosilicate (TAOS) and alkoxysilane (AS) expressed by the following general formula (I), which are contained in an organic solvent, in the presence of tetraalkyl ammonium hydroxide (TAAOH) and water,

   XₙSi(OR)₄₋ₙ (I)

   (wherein X denotes a hydrogen atom, a fluorine atom, an alkyl group having 1 to 8 carbon atoms, a fluorine substituted alkyl group, an aryl group, or a vinyl group; R denotes a hydrogen atom, an alkyl group having 1 to 8 carbon atoms, an aryl group, or a vinyl group; and n is an integer from 1 to 3.);
(b) subjecting at least a portion of the organic solvent contained in the liquid composition obtained in the step (a) to solvent substitution with an organic solvent selected from the group consisting of propylene glycol monopropyl ether (PGP), propylene glycol monomethyl ether (PGME), and propylene glycol monoethyl ether acetate (PGMEA); and
(c) adjusting an amount of a silicon compound contained in the liquid composition obtained in the step (b) and also adjusting an amount of water to that in the range of 30 to 60% by weight.

A method for preparing the second coating liquid for forming a low dielectric constant amorphous silica-based coating film according to the present invention is employed for preparing a coating liquid for forming an amorphous silica-based coating film having a low specific dielectric constant and a low leakage current, and the method comprises the steps of:
(a) preparing a liquid composition containing a silicon compound by hydrolyzing or partially hydrolyzing tetraalkyl orthosilicate (TAOS) which is contained in an organic solvent in the presence of a tetraalkyl ammonium hydroxide (TAAOH) and water, then mixing the hydrolyzed or partially hydrolyzed product with an alkoxysilane (AS) expressed by the general formula (I) above or a hydrolyzed or partial hydrolyzed product thereof, which is contained in an organic solvent, and further hydrolyzing all or a portion of resulting resultant mixture;
(b) subjecting at least a portion of the organic solvent contained in the liquid composition obtained in the step (a) with an organic solvent selected from the group consisting of propylene glycol monopropyl ether (PGP), propylene glycol monomethyl ether (PGME), and propylene glycol monoethyl ether acetate (PGMEA); and
(c) adjusting an amount of a silicon compound contained in the liquid composition obtained in the step (b) and also adjusting an amount of water to that in the range of 30 to 60% by weight.

In the methods for preparing a coating liquid, the organic solvent used in the step
(a) is preferably alcohols such as methanol, ethanol or propanol.
   The tetraalkyl orthosilicate (TAOS) used in the step (a) is preferably tetraethyl orthosilicate (TEOS), tetramethyl orthosilicate (TMOS), or a mixture thereof; the alkoxysilane (AS) used in the step (a) is preferably methyl trimethoxysilane (MTMS), methyl triethoxysilane (MTES), or a mixture thereof and the tetraalkyl ammonium hydroxide (TAAOH) used in the step (a) is preferably tetrapropyl ammonium hydroxide (TPAOH), tetrabutyl ammonium hydroxide (TBAOH), or a mixture thereof.
   The solvent substitution in the step (b) is preferably performed with a rotary evaporator.

On the other hand, the low dielectric constant amorphous silica-based coating film according to the present invention is preferably formed on a substrate by any of the following methods.
(1) A method in which the coating liquid for forming a low dielectric constant amorphous silica-based coating film according to the present invention is applied on a substrate, the substrate is heated at the temperature of 80 to 350 °C, and further is cured at the temperature of 350 to 450 °C, and
(2) A method in which the coating liquid for forming a low dielectric constant amorphous silica-based coating film according to the present invention is applied on a substrate, the substrate is heated at the temperature of 80 to 350 °C, and further an electron beam is irradiated to the substrate for curing.
   It is preferable that an average diameter of pores in the low dielectric constant amorphous silica-based coating film obtained as described above is 3 nm or below, and also that the pore volume of micropores each having a diameter of 2 nm or below is 75% or more in percentage to the total pore volume. Furthermore it is preferable that a maximum pore diameter in the coating film is 10 nm or below, and that an average diameter of mesopores each having a diameter of more than 2 nm is 4 nm or below.
   Furthermore, it is preferable that a specific dielectric constant of the coating film is 3.0 or below, and that an amount of a leakage current measured as a current density when a voltage of 0.5 MV/cm is applied to the coating film is not more than 1.4 x 10⁻¹⁰ A/cm².
   A Young's modulus of the coating film is preferably 6.0 GPa or more.
   Furthermore, preferable applications of the coating method include, for instance, an inter-layer insulating film formed on a semiconductor substrate.

### Effects of the Invention

With the coating liquid for forming a low dielectric constant amorphous silica-based coating film according to the present invention, it is possible to form on a substrate an amorphous silica-based coating film with a specific dielectric constant of 3.0 or below and a low leakage current. More specifically, it is possible to form a coating film in which an average diameter of pores is 3 nm or below and also a percentage of pore volume of micropores each having a diameter of 2 nm or below is 75% or more, and further it is possible to form a coating film in which a maximum diameter of pores is 10 nm or below and an average diameter of mesopores each having a diameter of more than 2 nm is 4 nm or below. In addition, it is possible to form a coating film having high film strength of 6.0 GPa or more as expressed by a Young's modulus and high moisture resistance (hydrophobicity). Because of the features, it is possible to obtain a coating film in which an amount of the leakage current measured as a current density when a voltage of 0.5 MV/cm is applied to the coating film is not more than 1.4 x 10⁻¹⁰ A/cm².
The low dielectric constant amorphous silica-based coating film having the low leakage current characteristics obtained as described above can sufficiently satisfy the recent requirements from semiconductor manufacturers and can advantageously be used.

### BEST MODE FOR CARRYING OUT THE INVENTION

A coating liquid for forming a low dielectric constant amorphous silica-based coating film and a method for preparing the coating liquid according to the present invention are described in detail below. Furthermore, a low dielectric constant amorphous silica-based coating film formed with the coating liquid according to the present invention is described in detail below.

### [Coating liquid for forming a low dielectric constant amorphous silica-based coating film]

A first coating liquid (Coating liquid A) according to the present invention is used for forming an amorphous silica-based coating film having a low specific dielectric constant and a low leakage current, and the coating liquid comprises:
(a) a silicon compound obtained by hydrolyzing tetraalkyl orthosilicate (TAOS) and alkoxysilane (AS) expressed by the following general formula (I) in the presence of tetraalkyl ammonium hydroxide (TAAOH) and water:

   XₙSi(OR)₄₋ₙ (I)

   (wherein X denotes a hydrogen atom, a fluorine atom, an alkyl group having 1 to 8 carbon atoms, a fluorine-substituted alkyl group, an aryl group, or a vinyl group; and R denotes a hydrogen atom, an alkyl group having 1 to 8 carbon atoms, an aryl group, or a vinyl group; and n is an integer from 1 to 3),
(b) an organic solvent, and
(c) water
   and is characterized in that a quantity of water contained in the liquid composition is in the range from 30 to 60% by weight.

A second coating liquid (Coating liquid B) according to the present invention is used for forming an amorphous silica-based coating film having a low specific dielectric constant and a low leakage current, and the coating liquid comprises:
(a) a silicon compound obtained by hydrolyzing or partially hydrolyzing tetraalkyl orthosilicate (TAOS) in the presence of tetraalkyl ammonium hydroxide (TAAOH) and water, mixing the hydrolyzed or partially hydrolyzed product with alkoxysilane (AS) expressed by the general formula (I) above or a hydrolyzed or partially hydrolyzed product thereof, and hydrolyzing all or a portion of the resultant mixture;
(b) organic solvent; and
(c) water,
   and is characterized in that a quantity of water contained in the liquid composition is in the range from 30 to 60% by weight.

The tetraalkyl orthosilicate (TAOS) includes, for instance, tetramethyl orthosilicate, tetraethyl orthosilicate, tetrapropyl orthosilicate, tetraisopropyl orthosilicate, and tetrabutyl orthosilicate. Of these compounds, the tetraalkyl orthosilicate (TAOS) used in the present invention is preferably tetraethyl orthosilicate (TEOS), tetramethyl orthosilicate (TMOS), or a mixture thereof.

The alkoxysilane (AS) described above, there can be enumerated, for instance, methyl trimethoxysilane, methyl triethoxysilane, methyl triisopropoxysilane, etyl trimethoxysilane, etyl triethoxysilane, etyl triisoprooxysilane, octyl trimethoxysilane, octyl triethoxysilane, vinyl trimethoxysilane, vinyl triethoxysilane, phenyl trimethoxysilane, phenyl triethoxysilane, trimethoxysilane, triethoxysilane, triisopropoxysilane, fluorotrimethoxysilane, fluoro-triethoxysilane, dimethyl dimethoxysilane, dimethyl diethoxysilane, diethyl dimethoxysilane, diethyl diethoxysilane, dimethoxysilane, diethoxysilane, difluoro dimethoxysilane, difluoro diethoxysilane, trifluoromethyl trimethoxysilane, trifluoromethyl triethoxysilane. Of these compounds, the alkoxysilane (AS) used in the present invention is preferably methyl trimethoxysilane (MTMS), methyl triethoxysilane (MTES), or a mixture thereof.

Furthermore, as the tetraalkyl ammonium hydroxide (TAAOH), there can be enumerated, for instance, tetramethyl ammonium hydroxide, tetraethyl ammonium hydroxide, tetrapropyl ammonium hydroxide, tetrabutyl ammonium hydroxide, tetra n-octyl ammonium hydroxide, n-hexadecyl trimethyl ammonium hydroxide, n-octadecyl trimethyl ammonium hydroxide, and the like. Of these compounds, as the tetraalkyl ammonium hydroxide (TAAOH) used in the present invention, it is preferable to use tetrapropyl ammonium hydroxide (TPAOH), tetrabutyl ammonium hydroxide (TBAOH), or a mixture thereof.

As the organic solvent, there can be enumerated alcohols, ketones, glycols, glycol ethers, esters, and the like which is compatible with water and can disperse the silicon compound. Of these compounds, an organic solvent containing any selected from the group consisting of propylene glycol monopropyl ether (PGP), propylene glycol monomethyl ether (PGME), and propylene glycol monoethyl ether acetate (PGMEA) is preferably used as the organic solvent in the present invention. Especially, because propylene glycol monopropyl ether (PGP) is very stable when the silicon compound is dispersed therein and a life of a coating liquid containing the material is long, it is preferable to use the propylene glycol monopropyl ether (PGP) in the present invention. Furthermore, when propylene glycol monopropyl ether (PGP) is contained in the organic solvent, a surface tension of the coating liquid can be lowered.
The water described above is preferably pure water or ultrapure water not containing any impurity ion.

In the coating liquid according to the present invention, a content of water in the liquid composition is preferably in the range from 30 to 60% by weight, and more preferably in the range from 35 to 50% by weight against the liquid composition. When the water content is less than 30% by weight, stability of the coating liquid deteriorates and the life becomes shorter, and furthermore an amount of leakage current increases in a coating film formed with the coating liquid. When the water content is over 60% by weight, a surface tension of the coating liquid becomes higher, and the coating liquid is repelled on an applied surface of a silicon wafer or a protective film such as a CMP sacrifice film, an etching stopper film and other mask films for semiconductor processing, and as a result it becomes difficult to form a homogeneous coating film on the entire applied surface.
A content of the silicon compound is preferably in the range from 2 to 20% by weight and more preferably in the range from 3 to 15% by weight against the liquid composition. When the content of the silicon compound is over 20% by weight, stability of the coating liquid becomes lower with the lapse of time. When the content of the silicon compound is less than 2% by weight, it becomes difficult to form a homogeneous coating film on a substrate.
The organic solvent is a balance component constituting the liquid composition. There is no specific restriction over the content, but the contents are preferably in the range from 20 to 68% by weight against the liquid composition.

### [Method of Preparing a coating liquid for forming a low dielectric constant amorphous silica-based coating film]

### [Coating liquid A]

A method for preparing the first coating liquid for forming a low dielectric constant amorphous silica-based coating film (Coating liquid A) according to the present invention is employed for preparing a coating liquid for forming an amorphous silica-based coating film having a low specific dielectric constant and a low leakage current, and the method comprises the steps of:
(a) preparing a liquid composition containing a silicon compound obtained by hydrolyzing tetraalkyl orthosilicate (TAOS) and alkoxysilane (AS) expressed by the following general formula (I), which are contained in an organic solvent, in the presence of tetraalkyl ammonium hydroxide (TAAOH) and water,

   XₙSi(OR)₄₋ₙ (I)

   (wherein X denotes a hydrogen atom, a fluorine atom, an alkyl group having 1 to 8 carbon atoms, a fluorine substituted alkyl group, an aryl group, or a vinyl group; R denotes a hydrogen atom, an alkyl group having 1 to 8 carbon atoms, an aryl group, or a vinyl group; and n is an integer from 1 to 3.);
(b) subjecting at least a portion of the organic solvent contained in the liquid composition obtained in the step (a) to solvent substitution with an organic solvent selected from the group consisting of propylene glycol monopropyl ether (PGP), propylene glycol monomethyl ether (PGME), and propylene glycol monoethyl ether acetate (PGMEA); and
(c) adjusting an amount of a silicon compound contained in the liquid composition obtained in the step (b) and also adjusting an amount of water to that in the range of 30 to 60% by weight.

The tetraalkyl orthosilicate (TAOS) includes, for instance, tetramethyl orthosilicate, tetraethyl orthosilicate, tetrapropyl orthosilicate, tetraisopropyl orthosilicate, and tetrabutyl orthosilicate. Of these compounds, the tetraalkyl orthosilicate (TAOS) used in the present invention is preferably tetraethyl orthosilicate (TEOS), tetramethyl orthosilicate (TMOS), or a mixture thereof.

The alkoxysilane (AS) described above, there can be enumerated, for instance, methyl trimethoxysilane, methyl triethoxysilane, methyl triisopropoxysilane, etyl trimethoxysilane, etyl triethoxysilane, etyl triisoprooxysilane, octyl trimethoxysilane, octyl triethoxysilane, vinyl trimethoxysilane, vinyl triethoxysilane, phenyl trimethoxysilane, phenyl triethoxysilane, trimethoxysilane, triethoxysilane, triisopropoxysilane, fluorotrimethoxysilane, fluoro-triethoxysilane, dimethyl dimethoxysilane, dimethyl diethoxysilane, diethyl dimethoxysilane, diethyl diethoxysilane, dimethoxysilane, diethoxysilane, difluoro dimethoxysilane, difluoro diethoxysilane, trifluoromethyl trimethoxysilane, trifluoromethyl triethoxysilane. Of these compounds, the alkoxysilane (AS) used in the present invention is preferably methyl trimethoxysilane (MTMS), methyl triethoxysilane (MTES), or a mixture thereof.

Furthermore, as the tetraalkyl ammonium hydroxide (TAAOH), there can be enumerated, for instance, tetramethyl ammonium hydroxide, tetraethyl ammonium hydroxide, tetrapropyl ammonium hydroxide, tetrabutyl ammonium hydroxide, tetra n-octyl ammonium hydroxide, n-hexadecyl trimethyl ammonium hydroxide, n-octadecyl trimethyl ammonium hydroxide, and the like. Of these compounds, as the tetraalkyl ammonium hydroxide (TAAOH) used in the present invention, it is preferable to use tetrapropyl ammonium hydroxide (TPAOH), tetrabutyl ammonium hydroxide (TBAOH), or a mixture thereof.

It is generally known that tetraalkyl ammonium hydroxide (TAAOH) procurable for general purposes from the market include compounds of alkali metal elements such as sodium (Na) and potassium (K), and compounds of halogen group elements such as bromine (Br) and chloride (Cl) as impurities each by a content in the range from a few hundred ppm (per parts million) by weight to a few percent by weight as an element base.
However, when a content of impurity comprising a compound of any alkali metal element such as sodium (Na) or potassium (K) is more than 50 ppb by weight as each element base, the compound is dispersed in a transistor section constituting a semiconductor substrate, which in turn may cause degradation of the transistor. In addition, when a content of impurity comprising a compound of any halogen group element such as bromine (Br) or chlorine (Cl) is more than 1 ppm by weight as each element base, sometimes aluminum wiring or copper wiring constituting semiconductor substrate deteriorates, which in turn may give fatal damages to the substrate. When contents of the impurities are large, opportunities of generation of the leakage current increase.

Furthermore, the present inventers found that, when a content of impurities comprising compounds of the alkali metal elements is more than 50 ppb by weight, the impurities function as a catalyst when tetraalkyl orthosilicate (TAOS) and alkoxysilane (AS) expressed by the general formula (I) are hydrolyzed in the presence of tetraalkyl ammonium hydroxide (TAAOH), and that the obtained silicon compound is zeolite-like crystalline silica. As a result, as the silica-based coating film formed on a substrate is a zeolytic crystalline substance, the coating film surface is irregular, which makes it difficult to obtain a smooth surface.
Therefore, when tetraalkyl ammonium hydroxide (TAAOH) procurable from the market and having the characteristics as described above is used, it is necessary to reduce the impurities contained therein to the levels described above respectively. Namely, the tetraalkyl ammonium hydroxide (TAAOH) used in the method according to the present invention is preferably highly purified by subjecting tetraalkyl ammonium hydroxide procured as a market product to the cation-exchange process and also the anion-exchange process to substantially remove impurities comprising compounds of alkali metal elements such as sodium (Na) and potassium (K) or those of halogen group elements such as bromine (Br) and chlorine (Cl). It is needless to say that, when tetraalkyl ammonium hydroxide, from which the impurities are previously removed, is procurable from the market, the market product may be used in the present invention.

A molar ratio (TAOS/AS) between the tetraalkyl orthosilicate (TAOS) and the alkoxysilane (AS) is preferably in the range from 6/4 to 2/8 and more preferably in the range from 5/5 to 3/7 in terms of SiO₂. When the molar ratio is over 6/4, hydrophobicity of the obtained silica-based coating film becomes lower. When the molar ratio is less than 2/8, the template effect by the tetraalkyl ammonium hydroxide (TAAOH) becomes smaller, so that the number of pores formed in the coating film (pore volume) become fewer, which makes it difficult to obtain a silica-based coating film having a specific dielectric constant of 3.0 or below (especially 2.5 or below).

Furthermore, when a molar ratio (TAAOH/(TAOS+AS)) between tetraalkyl ammonium hydroxide (TAAOH) and components for forming a silica-based coating film (TAOS and AS) is preferably in the range from 1/10 to 7/10, and more preferably in the range from 1/10 to 6/10 in terms of SiO₂ (for TAOS and AS). When the molar ratio is less than 1/10, the function as a template material is weak, so that the number of pores formed in the coating film (pore volume) becomes fewer, which makes it difficult to obtain a silica-based coating film having a specific dielectric constant of 3.0 or below. When the molar ratio is over 7/10, the function as a template material becomes too strong, so that the number of pores formed in the coating film (pore volume) becomes larger, which makes it difficult to obtain a silica-based coating film having high film strength of 6.0 GPa or more as expressed by a Young's modulus. Furthermore, when a silica-based coating film is formed on a semiconductor substrate, some of the tetraalkyl ammonium hydroxide (TAAOH) may remain in the coating film and give negative effects to functions of a semiconductor.

As the organic solvent used in the step (a), there can be enumerated alcohols, ketones, glycols, glycol ethers, esters, hydrocarbons, and the like. More specifically, there can be enumerated alcohols such as methanol, ethanol, propanol, and butanol; ketones such as methyl ethyl ketone, and methyl isobutyl ketone; glycols such as ethylene glycol, propylene glycol, and hexylene glycol; glycol ethers such as methyl cellosolve, ethyl cellosolve, and propylene glycol monopropyl ether; esters such as methyl acetate, ethyl acetate, methyl lactate, and ethyl lactate; hydrocarbons such as hexane, cyclohexane, and octane; and aromatic hydrocarbons such as toluene, xylene, and mesitylene. Of these compounds, in the present invention, it is preferable to use alcohols such as methanol, ethanol, and propanol. Especially, ethanol is safe and has high dispersibility, so that it is desirable to use ethanol in the present invention.
There is no specific restriction over a use rate of the organic solvent, and a mixing ratio (OS/(TAOS+AS)) in weight of the organic solvent (OS) against components for forming a silica-based coating film (TAOS+AS) is preferable in the range from 1/1 to 3/1, and more preferably in the range from 1/1 to 2.5/1.

Next, a method for preparing the coating liquid for forming the coating film (Coating liquid A) according to the present invention is described in further details.

### Step (a)

The step (a) is preferably performed in the mode as described below. With this step, it is possible to obtain a liquid composition containing silicon compounds which are hydrolysates of tetraalkyl orthosilicate (TAOS) and the alkoxysilane (AS).
(i) Tetraalkyl orthosilicate (TAOS) and the alkoxysilane (AS) expressed by the general formula (I) above are mixed with the organic solvent, and then the resultant mixture is agitated at the temperature of 10 to 30 °C and at the rotational speed of 100 to 200 rpm until the components are fully mixed,
(ii) Then, an aqueous solution of tetraalkyl ammonium hydroxide (TAAOH) is dripped in the mixture solution being agitated over 5 to 20 minutes, and the mixture solution is agitated for 30 to 90 minutes at the temperature in the range from 10 to 30 °C and at the rotational speed of 100 to 200 rpm.
(iii) Then the mixture solution is heated to the temperature in the range from 30 to 80 °C, and is agitated for 1 to 72 hours at the temperature and at the rotational speed of 100 to 200 rpm.

In this case, instead of the dripping method (in which an aqueous solution of the tetraalkyl ammonium hydroxide (TAAOH) prepared in (ii) above is dripped in a mixture solution prepared in (i) above containing the TAOS, AS, and the organic solvent), a mixture solution comprising the tetraalkyl orthosilicate (TAOS), alkoxysilane (AS), and an organic solvent prepared in (i) above is dripped slowly over 30 to 90 minutes in an aqueous solution of the tetraalkyl ammonium hydroxide (TAAOH) prepared in (ii) above under the same conditions as those described above (at the temperature in the range from 10 to 30 °C, and at the agitating speed of 100 to 200 rpm).
The tetraalkyl orthosilicate (TAOS), the alkoxysilane (AS), and the tetraalkyl ammonium hydroxide (TAAOH) are mixed with each other or added at the molar ratios described above respectively.

The aqueous solution of tetraalkyl ammonium hydroxide (TAAOH) dripped in the mixture solution contains tetraalkyl ammonium hydroxide (TAAOH) preferably by 5 to 40% by weight and more preferably by 10 to 30% by weight in pure water or ultrapure water. Since the water contained in the aqueous solution is used for effecting the hydrolysis reaction of tetraalkyl orthosilicate (TAOS) and alkoxysilane (AS), the quantity must be sufficient for the hydrolysis reaction. Because the tetraalkyl ammonium hydroxide (TAAOH) has a function as a catalyst for promoting the hydrolysis reaction, it is not necessary to add any specific catalyst (such as ammonia) from the outside.
The hydrolysis reaction is preferably performed at the temperature in the range from 30 to 80 °C, and more preferably from 35 to 60 °C with agitation for 1 to 72 hours, and more preferably for 10 to 48 hours.
A number average molecular weight of the silicon compounds (hydrolysates of TAOS and AS) contained in the liquid composition obtained as described above is preferably in the range 500 to 200000, and more preferably in the range from 1000 to 100000 in terms of polyethylene oxide. When the number average molecular weight is in the range described above, it is possible to prepare a coating liquid for forming a coating film having excellent stability even with the lapse of time and excellent adaptability on which the coating liquid is applied.

### Step (b)

The step (b) is preferably performed with a rotary evaporator procurable from the market in the following mode. With the step (b), the liquid composition containing the organic solvent used in the step (a) is subjected to a solvent substitution system, and the above organic solvent is substituted with the other organic solvent as described above, can be obtained. An example using propylene glycol monopropyl ether (PGP) as the organic solvent is shown below.
(i) The liquid composition obtained in the step (a) is placed in a flask of a rotary evaporator, and furthermore propylene glycol monopropyl ether (PGP) or a mixture solution of propylene glycol monopropyl ether (PGP) and water is added in a flask.
(ii) Then the rotary evaporator is run to rotate the flask at a rotational speed in the range from 30 to 120 rpm, and more preferably in the range from 60 to 90 rpm under the conditions for decompression at the temperature in the range from 50 to 90° C, and more preferably in the range from 60 to 80° C and the pressure in the range from -0.05 to -0.1 MPa, and more preferably in the range from -0.08 to -0.1 MPa. With this operation, the organic solvent used in the step (a) (such as ethanol) and water are evaporated, so that the vapor is cooled and discharged to the outside of the system.

(iii) By carrying out the operation in (ii) above for a required period of time, the liquid composition, in which the organic solvent is replaced with propylene glycol monopropyl ether (PGP), is obtained.
   Furthermore, it is also possible in the operation of (i) above to perform the solvent substitution by placing only the liquid composition obtained in the step (a) in the flask of the rotary evaporator, performed the operation in (ii) above, having the evaporated organic solvent and water discharged, and then adding propylene glycol monopropyl ether (PGP) or a mixture of propylene glycol monopropyl ether (PGP) and water. In this case, however, sometimes the silicon compound contained in the liquid composition may be denatured, and therefore caution is required.
   In this step (b), the organic solvent or water contained in the liquid composition obtained in the step (a), or alcohols or the like produced as a byproduct through hydrolysis of alkoxysilane (AS) or the like are separated and removed. By carrying out the operation in this step with a rotary evaporator, the solvent substitution as described above can be performed completely, but in the present invention, it is not always necessary to perform the solvent substitution completely.

### Step (c)

The step (c) is preferably carried out in the following mode. With the step (c), it is possible to obtain a liquid composition containing silicon compositions by adjusting a content of silicon compounds contained in the liquid composition obtained in the step (b) and also adjusting the water content to the range from 30 to 60 % by weight.
(i) Composition of the liquid composition obtained in the step (b) is measured.
(ii) Then, pure water or ultrapure water, or an aqueous solution of propylene glycol monopropyl ether (PGP) is added with agitation to the liquid composition to adjust a content of the silicon compound contained in the liquid composition and also to adjust the water content.

As described above, a content of water contained in the liquid composition is adjusted preferably to that in the range from 30 to 60% by weight, and more preferably to that in the range from 35 to 50% by weight against a weight of the liquid composition. When the water content is less than 30% by weight, stability of the coating liquid is low and the life is short, and in addition an amount of the leakage current increases in a coating film formed with the coating liquid. When the content is over 60% by weight, a surface tension of the coating liquid becomes higher, and the coating liquid is repelled on an applied surface of a silicon wafer, a protective film as described above for semiconductor processing and the like. As a result, it becomes difficult to form a homogeneous film over the applied surface.
Furthermore, it is preferable to adjust a content of the silicon compound preferably to that in the range from 2 to 20% by weight and more preferably to that in the range from 3 to 15% by weight against the liquid composition. When the content is over 20% by weight, stability of the coating liquid becomes lower with the lapse of time. When the content is less than 2% by weight, it becomes difficult to form a homogeneous coating film on a substrate.

The organic solvent is a balance component constituting the liquid composition, and there is not any specific restriction over the content, but the content is preferably in the range from 20 to 68% by weight. The content of an organic solvent as used herein means a sum of a solvent used for solvent substitution in the step (b) and an organic solvent still remaining therein (used in the step (a)).
With these steps as described above, it is possible to obtain a coating liquid A for forming an amorphous silica-based coating film having a low specific dielectric constant and a low leakage current.

### [Coating liquid B]

A method for preparing the second coating liquid for forming a low dielectric constant amorphous silica-based coating film (Coating liquid B) according to the present invention is employed for preparing a coating liquid for forming an amorphous silica-based coating film having a low specific dielectric constant and a low leakage current, and the method comprises the steps of:
(a) preparing a liquid composition containing a silicon compound by hydrolyzing or partially hydrolyzing tetraalkyl orthosilicate (TAOS) which is contained in an organic solvent in the presence of a tetraalkyl ammonium hydroxide (TAAOH) and water, then mixing the hydrolyzed or partially hydrolyzed product with an alkoxysilane (AS) expressed by the general formula (I) above or a hydrolyzed or partial hydrolyzed product thereof, which is contained in an organic solvent, and further hydrolyzing all or a portion of resulting mixture;
(b) subjecting at least a portion of the organic solvent contained in the liquid composition obtained in the step (a) with an organic solvent selected from the group consisting of propylene glycol monopropyl ether (PGP), propylene glycol monomethyl ether (PGME), and propylene glycol monoethyl ether acetate (PGMEA); and
(c) adjusting an amount of a silicon compound contained in the liquid composition obtained in the step (b) and also adjusting an amount of water to that in the range of 30 to 60% by weight.

Tetraalkyl orthosilicate (TAOS), alkoxysilane (AS), and tetraalkyl ammonium hydroxide (TAAOH) may be the same as those used for preparing the coating liquid A.
As for the tetraalkyl ammonium hydroxide (TAAOH), like in the case of the coating liquid A, it is necessary to substantially remove impurities including compounds of alkali metal elements such as sodium (Na), potassium (K) and compounds of halogen group elements such as bromine (Br), chlorine (Cl) by subjecting tetraalkyl ammonium hydroxide procurable from the market to processing with cation-exchange resin and anion-exchange resin. Namely, it is necessary to lower contents of compounds of alkali metal elements such as sodium (Na) or potassium (K) to 50 ppb by weight or below as each element base and also to lower contents of compounds of halogen elements such as bromine (Br) or chlorine (Cl) to 1 ppm by weight or below as each element base.

The liquid composition (Coating liquid B) is prepared by hydrolyzing or partially hydrolyzing tetraalkyl orthosilicate (TAOS) in the presence of tetraalkyl ammonium hydroxide (TAAOH) and water, mixing the hydrolyzed product or partially hydrolyzed product with alkoxysilane (AS) or a hydrolyzed product or a partially hydrolyzed product thereof, and furthermore hydrolyzing all or a portion of the resultant mixture.
When the alkoxysilane (AS) is previously hydrolyzed (or partially hydrolyzed) and then mixed, the hydrolysis is preferably performed in the presence of tetraalkyl ammonium hydroxide (TAAOH), like when hydrolyzing (or partially hydrolyzing) tetraalkyl orthosilicate (TAOS).

In this mixing step, a molar ratio (TAAOH/TAOS and TAAOH/AS) of tetraalkyl ammonium hydroxide (TAAOH) against the components for forming a silica-based coating film, namely against tetraalkyl orthosilicate (TAOS) and alkoxysilane (AS) is, like in the coating liquid A, preferably in the range from 1/10 to 7/10, and more preferably in the range from 1/10 to 6/10 in terms of SiO₂ (for TAOS and AS). Therefore, a molar ratio (TAAOH/(TAOS+AS)) of the tetraalkyl ammonium hydroxide (TAAOH) against the components for forming a silica-based coating film (TAOS+AS) is, like in the case of the coating liquid A, preferably in the range from 1/10 to 7/10 and more preferably in the range from 1/10 to 6/10 in terms of SiO₂ (for TAOS and AS).
When mixing the components, like in preparation of the coating liquid A, a molar ratio (TAOS/AS) of tetraalkyl orthosilicate (TAOS) against alkoxysilane (AS) is preferably set in the range from 6/4 to 2/8 and more preferably in the range from 5/5 to 3/7 in terms of SiO₂.

The method for preparing the coating liquid for forming a coating film (Coating liquid B) according to the present invention is described in further details.

### Step (a)

The step (a) is preferably carried out in the following mode. With this step, it is possible to obtain a liquid composition containing silicon compounds which are hydrolysates of tetraalkyl orthosilicate (TAOS) and alkoxysilane (AS). The mode is divided into the "method (1) for preparing silicon compounds" and "method (2) for preparing silicon compounds".

### Method (1) for preparing silicon compounds

(i) Tetraalkyl orthosilicate (TAOS) is mixed with an organic solvent, and the mixture is fully agitated at the temperature of 10 to 30 °C and at the rotational speed of 100 to 200 rpm until the components are fully mixed with each other.
(ii) Then, an aqueous solution of tetraalkyl ammonium hydroxide (TAAOH) is dripped in the mixture solution being agitated over 5 to 20 minutes, and the resultant mixture solution is agitated for 30 to 90 minutes at the temperature of 10 to 30 °C and the rotational speed of 100 to 200 rpm.
(iii) Then the mixture solution is heated to the temperature in the range from 30 to 80 °C and agitated for 0.5 to 72 hours at the temperature and at the rotational speed of 100 to 200 rpm to prepare a mixture solution containing a hydrolyzed product or a partially hydrolyzed product of tetraalkyl orthosilicate (TAOS).
(iv) Furthermore, after alkoxysilane (AS) expressed by the general formula (I) above or a mixture of alkoxysilane (AS) and an organic solvent is mixed in the mixture solution obtained in (iii) above, and the mixture solution is agitated at the temperature of 10 to 30 °C and at the rotational speed of 100 to 200 rpm until the ingredients are fully mixed with each other.

(v) Then an aqueous solution of tetraalkyl ammonium hydroxide (TAAOH) is dripped in the mixture solution being agitated over 5 to 20 minutes, and the mixture solution is furthermore agitated for 30 to 90 minutes at the temperature of 10 to 30 °C and at the rotational speed of 100 to 200 rpm.
(vi) Then the mixture solution obtained in (v) above is heated to the temperature in the range from 30 to 80 °C and is agitated for 10 to 30 hours at the temperature and at the rotational speed of 100 to 200 rpm.
In this step, instead of dripping the aqueous solution obtained in (ii) above in the mixture solution comprising TAOS and an organic solvent prepared in (i) above, the mixture solution comprising tetraalkyl orthosilicate (TAOS) and an organic solvent prepared in (i) above may slowly be dripped in an aqueous solution of tetraalkyl ammonium hydroxide (TAAOH) prepared in (ii) above over 30 to 90 minutes under the same conditions as those described above (at the temperature of 10 to 30 °C and at the rotational speed of 100 to 200 rpm).

### Method (2) for preparing silicon compounds

(i) Tetraalkyl orthosilicate (TAOS) is mixed with an organic solvent, and the mixture is fully agitated at the temperature of 10 to 30 °C and at the rotational speed of 100 to 200 rpm until the components are fully mixed with each other.
(ii) Then, an aqueous solution of tetraalkyl ammonium hydroxide (TAAOH) is dripped in the mixture solution being agitated over 5 to 20 minutes, and the resultant mixture solution is agitated for 30 to 90 minutes at the temperature of 10 to 30 °C and the rotational speed of 100 to 200 rpm.
(iii) Then the mixture solution is heated to a temperature in the range from 30 to 80 °C and agitated for 30 to 90 minutes at the temperature and at the rotational speed of 100 to 200 rpm to prepare a mixture solution containing a hydrolyzed product or a partially hydrolyzed product of tetraalkyl orthosilicate (TAOS).
(iv) Furthermore, alkoxysilane (AS) expressed by the general formula (I) above and an organic solvent are mixed with each other, and the mixture is agitated at the temperature of 10 to 30 °C and at the rotational speed of 100 to 200 rpm until the components are filly mixed with each other.

(v) Then an aqueous solution of tetraalkyl ammonium hydroxide (TAAOH) is dripped in the mixture solution being agitated over 5 to 20 minutes, and the mixture solution is furthermore agitated for 30 to 90 minutes at the temperature of 10 to 30 °C and at the rotational speed of 100 to 200 rpm.
(vi) Then the mixture solution is heated to a temperature in the range from 30 to 80 °C, and is agitated for 0.5 to 72 hours at the temperature and at the rotational speed of 100 to 200 rpm to prepare a mixture solution containing a hydrolyzed product or a partially hydrolyzed product of alkoxysilane (AS).
(vii) Then the mixture solution obtained in (iii) above and the mixture solution obtained in (vi) above are mixed, and the mixture solution are agitated at the temperature of 10 to 30 °C and at the rotational speed of 100 to 200 rpm until the components are fully mixed with each other.
(viii) Furthermore, if necessary, the mixture solution obtained in (vii) above is heated to the temperature of 30 to 80 °C, and the mixture solution is agitated for 10 to 30 hours at the temperature and at the rotational speed of 100 to 200 rpm.

In this step, instead of dripping the aqueous solution of tetraalkyl ammonium hydroxide (TAAOH) prepared in (ii) above in the mixture solution of tetraalkyl orthosilicate (TAOS) and the organic solvent prepared in (i) above and also dripping the aqueous solution of TAAOH prepared in (v) above into the mixture solution comprising alkoxysilane (AS) and the organic solvent prepared in (iv) above, the mixture solution comprising tetraalkyl orthosilicate (TAOS) and the organic solvent prepared in (ii) above may be slowly dripped in the aqueous solution of tetraalkyl ammonium hydroxide (TAAOH) over 30 to 90 minutes under the same conditions as those described above (at the temperature of 10 to 30 °C and at the agitating speed of 100 to 200 rpm), and also the mixture solution comprising alkoxysilane (AS) and the organic solvent prepared in (iv) above may be slowly dripped over 30 to 90 minutes in the aqueous solution of tetraalkyl ammonium hydroxide (TAAOH) prepared in (v) above under the same conditions (at the temperature of 10 to 30 °C and at the agitating speed of 100 to 200 rpm) as those described above.

In the process described above, tetraalkyl orthosilicate (TAOS), alkoxysilane (AS), and tetraalkyl ammonium hydroxide (TAAOH) are mixed or added at the molar ratios as described above respectively.
As the organic solvent used in the process, the same one as that used for preparing the coating liquid A may be used. The organic solvents mixed in tetraalkyl orthosilicate (TAOS) and alkoxysilane (AS) may be different when types are the same (such as alcohols), but preferably the solvents are of the same.

There is no specific restriction over a use rate of the organic solvent, but like in the case of the coating liquid A, a mixing weight ratio (OS / (TAOS+AS)) of the organic solvent (OS) against the components for forming a silica-based coating film (TAOS and AS) is preferably in the range from 1/1 to 3/1 and more preferably in the range from 1/1 to 2.5/1. Therefore, after the mixing, the weight ratio (OS / (TAOS+AS)) of the organic solvent (OS) against the components for forming a silica-based coating film (TAOS and AS) becomes, like in the case of the coating liquid A, preferably in the range from 1/1 to 3/1, and more preferably in the range from 1/1 to 2.5/1.
Furthermore, an aqueous solution of tetraalkyl ammonium hydroxide (TAAOH) dripped in the mixture organic solvent contains tetraalkyl ammonium hydroxide (TAAOH) in pure water or in ultrapure water preferably by 5 to 40% by weight, and more preferably by 10 to 30% by weight like in the case of the coating liquid A.

The hydrolysis reaction is carried out, like in the case of the coating liquid A, preferably for 0.5 to 72 hours and more preferably for 10 to 48 hours at the temperature preferably in the range from 30 to 80 °C and more preferably in the range from 35 to 60 °C. In the methods (1) and (2) for preparing the silicon compounds, the time required for hydrolyzing each of tetraalkyl orthosilicate (TAOS) or alkoxysilane (AS) independently may be short, but in the next step the hydrolysis reaction is preferably performed (for instance, spending 10 to 30 hours) until the components are completely hydrolyzed.
The number average molecular weight of the silicon compounds (hydrolysates of TAOS and AS) contained in the liquid composition is preferably in the range from 500 to 200000, and more preferably in the range from 1000 to 100000 in terms of polyethylene oxide.

### Step (b)

The step (b) is preferably carried out in the following mode, like in the case of the coating liquid A. With the step (b), it is possible to obtain a liquid composition containing the silicon compound in which the organic solvent used in the step (a) has been substituted with the new organic solvent described above. An example using propylene glycol monopropyl ether (PGP) as the organic solvent is shown below.
(i) The liquid composition obtained in the step (a) above is put in a flask of a rotary evaporator, and also propylene glycol monopropyl ether (PGP) or a mixture solution of propylene glycol monopropyl ether (PGP) and water is added in the flask.
(ii) Then the rotary evaporator is run to rotate the flask at the temperature preferably in the range from 50 to 90 °C and more preferably in the range from 60 to 80 °C and at the rotational speed preferably in the range from 30 to 120 rpm and more preferably in the range from 60 to 90 rpm in the decompressed state preferably in the range from -0.05 to -0.1 MPa and more preferably in the range from -0.08 to -0.1 MPa. Then, the organic solvent (such as ethanol) used in the step (a) and water are evaporated, and the vapor is cooled and discharged to outside of the system.
(iii) By carrying out the operation in (ii) above for a required period of time, it is possible to obtain a liquid composition in which the organic solvent has been substituted with propylene glycol monopropyl ether (PGP).

In the operation of (i) above, also a method is allowable in which only the liquid composition obtained in the step (a) is put in the flask of the rotary evaporator; the operation in (ii) above is carried out; the evaporated organic solvent and water are discharged to outside of the system; and then propylene glycol monopropyl ether (PGP) or a mixture solution of propylene glycol monopropyl ether (PGP) and water is added for solvent substitution. In this case, however, the silicon compound contained in the liquid composition may denature, so that caution is required.
In the step (b), like in the case of the coating liquid A, the organic solvent or water, and furthermore alcohols and the like produced each as a byproduct of hydrolysis of alkoxysilane (AS) contained in the liquid composition obtained in the step (a) are removed and separated. By performed the operations in this step with a rotary evaporator, the solvent substitution described above can be carried out almost completely, and therefore it is not always required to carry out the operations completely.

### Step (c)

The step (c) is preferably carried out, like in the case of the coating liquid A, in the following mode. With this step, it is possible to obtain a liquid composition containing the silicon compound in which a content of silicon compounds contained in the liquid composition obtained in the step (b) has been adjusted and also the water content has been adjusted to that in the range from 30 to 60% by weight.
(i) Composition of the liquid composition obtained in the step (b) is measured.
(ii) Then contents of silicon compounds and water contained in the liquid composition are adjusted by adding pure water, ultrapure water, or an aqueous solution of propylene glycol monopropyl ether (PGP) with agitation to the liquid composition.

As described above, a content of water contained in the liquid composition is adjusted, like in the case of the coating liquid A, preferably to that in the range from 30 to 60% by weight and more preferably to that in the range from 35 to 50% by weight against the liquid composition.
Furthermore, a content of the silica compound is adjusted, like in the case of the coating liquid A, preferably to that in the range from 2 to 20% by weight, and more preferably to that in the range from 3 to 15% by weight.
The organic solvent is a balance component of the liquid composition like in the case of the coating liquid A, and there is no specific restriction over the content, but the content is preferably in the range from 20 to 68% by weight against the liquid composition.
With this step, it is possible to obtain the coating liquid B for forming an amorphous silica-based coating film having a low specific dielectric constant and a low leakage current.

### [Method for forming a low dielectric constant amorphous silica-based coating film]

The following methods are available for forming a low dielectric constant amorphous silica-based coating film according to the present invention.
(1) A method in which the coating liquid for forming a low dielectric constant amorphous silica-based coating film is applied on a substrate, then the substrate is heated at the temperature in the range from 80 to 350 °C, and then is cured at the temperature in the range from 350 to 450 °C (Coating film formation method A).
(2) A method in which the coating liquid for forming a low dielectric constant amorphous silica-based coating film is applied on a substrate, then the substrate is heated at the temperature in the range from 80 to 350 °C, and then is cured by irradiating an electron beam (Coating film formation method B).
   The coating film formation methods are described in detail below.

### [Coating film formation method A]

### Coating process

Generally, for applying a coating liquid for formation of a coating film, coating methods such as spin coat method, dip coat method, roll coat method, and transfer method are employed, and also in the present invention any of the known methods as described above can be employed for applying a coating liquid for forming a low dielectric constant amorphous silica-based coating film on a substrate. Of these methods as described above, the spin coat method is preferable for applying a coating liquid on a semiconductor substrate, and the spin coat method is excellent, because the method provides films with homogeneous film thickness and generates dusts little. Therefore, it is preferable to employ the spin coat method for applying a coating liquid, but the transfer method or other appropriate methods may be employed when a coating liquid is applied on a semiconductor substrate with a large size or the like.

The expression of "applying a coating liquid on a substrate" as used herein means not only that the coating liquid is directly applied on a substrate such as a silicon wafer, but also that the coating liquid is applied on a protective film as described above for semiconductor processing or on other films formed on the substrate.

### Heating process

The coating film applied on a substrate as described above is heated at the temperature from 80 to 350 °C.
When the heat treatment is carried out at the temperature more than 350 °C, the organic solvent contained in the applied coating film evaporates rapidly, and sometimes pores or voids each with a relatively larger diameter are formed in the coating film, which in turn lowers a strength of the coating film. Therefore, in the heat treatment, it is preferable to rise the temperature step by step to the range of 80 to 350 °C. For instance, heating is performed for one minute at the temperature of 150 °C, for one minute at the temperature of 250 °C, and furthermore for one minute at the temperature of 350 °C. When the heat treatment is performed at the temperature of less than 80 °C, the organic solvent contained in the coating film little evaporates and remains in the coating film in most cases, so that an object of the heat treatment is not achieved and sometimes a thickness of the formed coating film is not homogeneous.
A period of time required for the heat treatment varies according to a thickness of a coating film, and the heat treatment is preferably carried out for 1 to 10 minutes and more preferably for 2 to 5 minutes.

Furthermore, the heat treatment may be carried out in the atmosphere of a nitrogen gas as an inert gas or air. Because this treatment is carried out at a relatively low temperature of 350 °C or below and for a short period of time, even when the heat treatment is carried out in the atmospheric air containing a relatively large quantity of oxygen, there occurs no damage such as oxidation to metal wirings provided on a semiconductor substrate. Furthermore, the possibility that a small quantity of oxygen is introduced into the coating film becomes higher, which leads to generation of a silica-based coating film including a high degree of bridging based on the Si-O-Si bond in the curing process as described below, and therefore it becomes easier to form a low dielectric constant amorphous silica-based coating film having a high water resistance (hydrophobicity) and a high film strength.
When the heat treatment is carried out as described above, the organic solvent contained in the applied coating film evaporates, and some of tetraalkyl ammonium hydroxide (TAAOH) contained in the coating film is decomposed and desorbed out of the film. On the other hand, a degree of polymerization of components for forming a silica-based coating film as solid components advances to cause curing, and at the same time, melting viscosity of the polymerized material becomes lower during the heat treatment, so that the reflow property of the coating film increases and flatness of the surface of the obtained coating film is improved. The heat treatment is preferably carried out by placing the substrate obtained in the coating process on a sheet-feed type hot plate.

### Curing process

Then the coating film having been subjected to the heat treatment is cured in the atmosphere of an inert gas and at the temperature of 350 to 450 °C.
As the inert gas, preferably a nitrogen gas is used, and if necessary, the inert gas may be used together with a small quantity of oxygen by adding an oxygen gas or air (for instance, by around 500 to 10000 ppm by volume). (Refer to WO 01/48806 A.)

The temperature for curing varies dependent upon a type and a quantity of tetraalkyl ammonium hydroxide (TAAOH) used for preparing the coating liquid for forming a coating film or characteristics of the silicon compounds (components for forming a silica-based coating film) contained in the coating liquid, but it is desirable to select a temperature in the range from 350 to 450 °C to obtain a low dielectric constant amorphous silica-based coating film having moisture resistance (hydrophobicity) and a high film strength.
When the temperature employed in the curing process is less than 350 °C, bridging hardly occurs in a precursor of components for forming a silica-based coating film, so that a coating film having sufficient film strength can not be obtained. When the temperature employed in the curing process is over 450 °C, sometimes the aluminum wiring or copper wiring constituting the semiconductor substrate may be oxidized or fused, which may give fatal damages to the wiring layer.

A period of time required for the curing process varies dependent upon a type of components for forming a silica-based coating film, or thickness of the coating film, but preferably the curing process is performed for 5 to 90 minutes, and more preferably for 10 to 60 minutes.
Furthermore, it is preferable to carry out this curing process, like in the case of the heating process, by placing a substrate on a sheet-feed type hotplate.
A thickness of the silica-based coating film obtained as described above varies dependent upon a semiconductor substrate on which the coating film is formed or the purpose of its use, and for instance, on a silicon substrate (silicon wafer) for a semiconductor device, the thickness is generally in the range from 100 to 600 nm, and in a section between wirings for a multi-layered portion, the thickness is generally in the range from 100 to 1000 nm.

### [Coating film formation method B]

### Coating process

The coating liquid according to the present invention is applied, like in the coating film formation method A, on a substrate.

### Heating process

The coating film applied on the substrate as described above is heated at the temperature from 80 to 350 °C, like in the coating film formation method A.

### Curing process

The coating film having been subjected to the heating process as described above is then cured by irradiating an electron beam to the coating film in the atmosphere of an inert gas.
The irradiated electron beam preferably has an acceleration voltage in the range from 10 to 26 kV. When the acceleration voltage is over 26 kV, damages to a silicon substrate (a silicon wafer), a silica-based coating film formed thereon, or the like become serious, and furthermore a specific dielectric constant of the coating film may become higher than a desired value (3.0 or below). When the acceleration voltage is less than 10 kV, sometimes it is difficult to obtain a silica-based coating film having a desired film strength (for instance, with a Young's modulus of 8 GPa or more).

An irradiation dose of the electron beams is preferably in the range from 50 to 1000 µC/cm², and more preferably in the range from 300 to 600 µC/cm². When the irradiation dose is over 1000 µC/cm², sometimes a specific dielectric constant of the formed silica-based coating film is higher than a desired value (3.0 or below). When the irradiation dose is below 50 µC/cm², sometimes a silica-based coating film having a desired film strength (for instance, with a Young's modulus of 8 GPa or more) can not be obtained.
Irradiation of the electron beam is preferably carried out in the atmosphere of an inert gas such as a nitrogen gas heated to the temperature in the range from 280 to 410 °C and preferably in the range from 300 to 400 °C. When the temperature is over 410 °C, the aluminum wiring or copper wiring constituting the semiconductor substrate may be oxidized or fused, which may give fatal damages to the wiring layer. When the temperature is less than 280 °C, bridging hardly occurs in a precursor of components for forming a silica-based coating film, and sometimes a coating film having sufficient film strength can not be obtained.

Furthermore, a period of time required for the curing process varies dependent upon a type of a coating liquid for forming a coating film or a thickness of the coating film, but generally the curing processing is preferably carried out over 5 to 90 minutes, and more preferably over 10 to 60 minutes. Furthermore, this curing processing is preferably carried out by placing a substrate on a sheet-feed type hotplate, like in the heating process.
A thickness of the silica-based coating film obtained as described above varies dependent upon a semiconductor substrate on which the coating film is formed or the purpose of its use, and for instance, on a silicon substrate (silicon wafer) for a semiconductor device, the thickness is generally in the range from 100 to 600 nm on a silicon substrate (silicon wafer) of a semiconductor device, and in a section between wirings for a multi-layered portion, the thickness is generally in the range from 100 to 1000 nm.

### [Low dielectric constant amorphous silica-based coating film]

The low dielectric constant amorphous silica-based coating film according to the present invention can be obtained by the coating film forming method described above, and has a specific dielectric constant of 3.0 or below and a low leakage current. In other words, with the coating liquid for forming a low dielectric constant amorphous silica-based coating film according to the present invention, it is possible to form a coating film having pores with the average diameter of 3 nm or below and also with the pore volume of micropores each having a diameter of 2 nm or below being 75% or more in percentage to the total pore volume, and furthermore it is possible to form a coating film in which the maximum pore diameter is 10 nm or below and an average diameter of mesopores each having a diameter of more than 2 nm is 4 nm or below. In addition, it is possible to form a coating film having a high film strength of 6.0 GPa or more as expressed by the Young's modulus and high moisture resistance (hydrophobicity). Because of the features as described above, it is possible to obtain a coating film in which an amount of leakage current measured as a current density when a voltage of 0.5 MV/cm is applied to the coating film is not more than 1.4 x 10⁻¹⁰ A/cm². More specifically it is possible to obtain a coating film in which an amount of leakage current when a voltage of 0.2 MV/cm is applied is not more than 1.8 x 10⁻¹¹ A/cm², an amount of leakage current.when a voltage of 1.0 MV/cm is applied is not more than 3.6 x 10⁻⁹ A/cm², and an amount of leakage current when a voltage of 2.0 MV/cm is applied is not more than 4.2 x 10⁻⁸ A/cm². Therefore, the present invention can provide a low dielectric constant amorphous silica-based coating film that can satisfy the recent requirements from semiconductor manufacturers.

Other Characteristics and features of the low dielectric constant amorphous silica-based coating film according to the present invention are as described below.
(1) The coating film has a smooth surface with the surface roughness (Rms) of 1 nm or below. (This surface roughness is expressed with a surface roughness of square average of values measured with an atomic force microscope (AFM). Because of this feature, the complicated polishing process is not always required for smoothing a surface of a coating film formed on a substrate, and therefore the defects of a zeolitic coating film described above can be dissolved.
(2) The coating film itself is excellent in the hydrophobicity (moisture resistance), and even when the coating film is left in the atmospheric air containing saturated water vapor, different from the zeolitic coating film, the specific dielectric constant does not deteriorate (Namely the specific dielectric constant does not increase). Because of the feature, different from the zeolitic coating film, a surface of the coating film according to the present invention is not required to be subjected to silylation. The coating film is an amorphous silica-based coating film not having an X-ray diffraction peak as measured in the MFI crystal structure of zeolitic coating film.

(3) When used, the coating film is formed on a surface of a semiconductor substrate, between wirings in a multilayered wiring structure, a substrate with a device surface and/or a PN junction section provided thereon, or between multilayered wirings provided on the substrate. Of these usages described above, the use as an inter-layer insulating film formed on a semiconductor substrate or the like is advantageous.
(4) Furthermore, the coating film is excellent in chemical resistance such as adhesiveness to a surface of a semiconductor substrate or the like on which the coating film is formed and also in process adaptability such as oxygen plasma resistance and workability by etching.
   The present invention is described in detail below with reference to examples, but the present invention is not limited to the examples.

### Example 1

300 grams of cation-exchange resin powder (WK-40 produced by Mitsubishi Chemical Co., ltd.) were added to one kilogram of aqueous solution including tetrapropyl ammonium hydroxide with the concentration of 40% by weight (TPAOH produced by Lion Co., ltd.), and the mixed solution was agitated for one hour at the rotational speed of 100 rpm, at the room temperature, and the cation-exchange resin powder were discharged to the outside by filtering. Then 2100 grams of anion-exchange resin powder (SAT-10 produced by Mitsubishi Chemical, Co., ltd.) were added, and the mixed solution was agitated for one hour at the rotational speed of 100 rpm, at the room temperature, and the anion-exchange resin powder were discharged by filtering.
Ultra-pure water were added to tetrapropyl ammonium hydroxide (TPAOH) solution obtained from the above process, the solution was adjusted to concentration of 10% by weight, and contents of impurities in the solution including alkali metal elements such as sodium (Na) and potassium (K) and halogen group elements such as bromine (Br) and chlorine (Cl) were measured by using atomic absorption spectrophotometer (AAS method, Z-5710, Zeeman atomic absorption spectrophotometer produced by Hitachi Co., ltd.) and ion chromatography (2020i produced by DIONEX).

Furthermore, ultra-pure water were added to the tetrapropyl ammonium hydroxide solution (TPAOH produced by Lion Co., ltd.) to which the above ion-exchange process is not performed, concentration of the solution was adjusted to concentration of 10% by weight, and the contents of impurities in the solution were measured as described above.
As the result of the above measuring process, while the contents of the impurities before the ion-exchange were 50 ppm by weight of sodium, 2500 ppm by weight of potassium, 2250 ppm by weight of bromine, and 13 ppm by weight of chlorine as each element base, the contents of the impurities after the ion-exchange were 10 ppb by weight or below (which is a lower limit for detection) of sodium, 10 ppb by weight or below (which is a lower limit for detection) of potassium, 1 ppm by weight or below of bromine, and 1 ppm by weight or below of chlorine as each element base. The result indicates that the tetrapropyl ammonium hydroxide was highly purified to a level required by the present invention.

Then, 142.9 grams of tetraethyl orthosilicate (TEOS produced by Tama Chemicals Co., ltd.), 90.9 grams of methyltrimethoxysilane (MTTS produced by Shin-Etsu Chemical Co., ltd.), and 467.9 grams of 99.5% by weight of ethanol (ETOH produced by Wako Pure Chemical Industries Co., ltd.) were mixed, and the mixed solution were agitated for 30 minutes at the rotational speed of 150 rpm without changing the temperature of 20 °C.
298.3 grams of the highly purified aqueous solution of tetrapropyl ammonium hydroxide (including TPAOH by 10% by weight) were dripped in the mixed solution over 10 minutes, and the resultant mixture solution was agitated for one hour at the rotational speed of 200 rpm and at the temperature of 20 °C. Then, the solution were heated up to the temperature of 50 °C, and a hydrolysis of the components for forming a silica-based coating film (TEOS and MTMS) was performed by agitating the solution for 20 hour at the rotational speed of 200 rpm, without changing the temperature.

Then, the mixed solution including the hydrolysate (silicon compounds) of the components for forming a silica-based coating film was placed in a flask of a rotary evaporator (R-114, produced by Shibata Scientific Technology Co., ltd.), 400 grams of a mixture solution containing pure water by 50% by weight and propylene glycol monopropyl ether by 50% by weight was added to the solution, and solvent substitution of the solution into propylene glycol monopropyl ether (PGP produced by Nippon Nyukazai Co., ltd) was performed. When the substitution was performed, the rotary evaporator was operated to rotate the flask at the rotational speed of 70 ppm under the conditions at the temperature of 70 °C and the pressure of -0.09 MPa (in the decompressed state).
As the result of the above solvent substitution, a liquid composition including silicon compounds by about 5% by weight, propylene glycol monopropyl ether by about 30% by weight, ethanol by about 40% by weight, and water by about 25% by weight was obtained.

Then the 100-grams fractions of the liquid composition were taken out, and pure water and/or propylene glycol monopropyl ether were added to each of the fraction, the content of water and the silicon compounds was adjusted as shown in Table 1, and the sample was agitated for one hour at the rotational speed of 200 rpm. With the operation as described above, liquid compositions (coating liquid for forming coating film) each having the composition shown in Table 1 were obtained. Contents (weight %) of the silicon compounds shown in Table 1 were measured by converting from the quantities of residual solid materials obtained by drying a portion of each of the liquid compositions at 150 °C. (When the liquid composition is dried at the temperature of 150 °C, the organic solvent and water contained in the liquid composition are evaporated as they are, and furthermore tetramethyl ammonium hydroxide (TMAOH) and the like are decomposed and evaporated, so that the silicon compounds remain as solid materials.)

5 ml of the coatings liquid for forming the coating film obtained as described above was dripped by the known spin coat method (ACT-8 produced by Tokyo Electron Co., ltd.) onto an 8-inch silicon wafer substrate, and a coatings process was carried out for 20 seconds at the rotational speed of 2000 rpm. A plurality of substrates having been subjected to the coating process were obtained by repeating the operations above.
The substrates were placed on a sheet-feed type hot plate (produced by Tokyo Electron Co., ltd.), and was heated for 3 minutes in a nitrogen gas atmosphere and at the temperature of 150 °C. In this heating process, the organic solvents (PGP and ethanol) are evaporated, and the vaporized materials were discharged to outside of the system.
Furthermore, in the state where the substrates were placed on the sheet-feed type hot plate, the substrates were cured in the nitrogen atmosphere for 30 minutes at the temperature of 400 °C. Then the substrates (Example substrates (1) to (3)) were cooled down to a temperature near the room temperature, and taken out of the system.
A thickness of the silica-based coating film formed on the substrate obtained as described above was about 500 nm (when measured with a spectroscopic Ellipsometer ESVG produced by SOPRA).

Then the measurement was performed for properties of the silica-based coating film formed on the substrate, namely (i) an average diameter of pores (by means of nitrogen absorption method with Autosorb-1 produced by Quanta Chrome Co., ltd.), (ii) pore distribution (pore volume ratios of micropores each having the diameter of 2 nm or below and mesopores each having a diameter of more than 2 nm by means of the nitrogen absorption method with Autosorb-1 produced by Quanta Chrome Co., ltd.), (iii) a film strength (Young's modulus by means of nano-indentation method with Nano Indenter XP produced by MTS Systems Co., ltd.), (iv) changes in a moisture absorption rate before and after irradiation of oxygen plasma (by means of TDS method: Desorption Mass-Spectroscopy, with EMD-1000 produced by Denshi Kagaku K. K.). The result is shown in Table 2.
Furthermore, the measurement was performed for properties of the silica-based coating film formed on the substrate, namely (v) a specific dielectric constant (by means of mercury probe method at a frequency of 1 MHz with SSM495 produced by Solid State Measurement Co., ltd.) and (vi) amount of leakage current (by means of mercury probe method with SSM495 produced by Solid State Measurement Co., ltd.). The result is shown in Table 3.
It is to be noted that the processors, measuring equipment, and analyzers used in Example 1 were also used in Example 2 and Comparative Example 1 described below.

### Example 2

85.7 grams of tetraethyl orthosilicate (TEOS, produced by Tama Chemicals Co., ltd.), and 146.6 grams of ethanol with the concentration of 99.5% by weight (ETOH produced by Wako Pure Chemical Industries, ltd.) were mixed, the mixture solution was kept at the temperature of 20 °C, and was agitated for 30 minutes at the rotational speed of 150 rpm. Then 89.5 grams of the highly purified aqueous solution of tetrapropyl ammonium hydroxide (including TPAOH by 10% by weight) was dripped over 10 minutes, and then agitated for 2 hours at the rotational speed of 150 rpm at the temperature of 20 °C. Then, the solution was heated up to the temperature of 50 °C, and the solution was agitated for 40 hours at the rotational speed of 200 rpm at the same temperature to hydrolyze the tetraethyl orthosilicate.
Then, a mixed solution in which 127.3 grams of methyltrimethoxysilane (MTMS produced by Shin-Etsu Chemical Co., ltd.) and 342.1 grams of ethanol with the concentration of 99.5% by weight (ETOH produce by Wako Pure Chemical Industries, Co., ltd.) were mixed into the hydrolyzed solution, and the mixed solution was agitated for 10 minutes at the speed of 150 rpm, at the temperature of 20 °C. Then, 208.8 grams of the highly purified tetrapropyl ammonium hydroxide solution (including TPAOH by 10% by weight) were dripped over 10 minutes, then was agitated for one hour at the speed of 150 rpm and at the temperature of 20 °C. Then, the solution was heated up to the temperature of 50 °C, agitated for 25 hours at the rotational speed of 200 rpm without changing the temperature to hydrolyze methyl trimethoxysilane and other hydrolyzed components (partial hydrolysates of tetraethyl orthosilicate and the like).

Then, under the same conditions employed in Example 1, the mixture solution containing hydrolytes (silicon compounds) of the components for forming a silica-based coating film obtained as described above was put in a flask of a rotary evaporator (R-114 produced by Shibata Scientific Technology Co., ltd.), and furthermore 400 grams of mixture solvent containing pure water by 50% by weight and propylene glycol monopropyl ether by 50% by weight were added to the solution, and the ethanol was substituted with propylene glycol monopropyl ether (PGP produced by Nippon Nyukazai Co., ltd).
As a result, a liquid composition including the silicon compounds by about 5% by weight, propylene glycol monopropyl ether by about 30% by weight, ethanol by about 40% by weight, and water by about 25% by weight was obtained.
Then 100 gram fractions of the liquid composition were taken out, water and/or propylene glycol monopropyl ether were added to the composition, the concentrations of water and silicon compounds were adjusted as shown in Table 1, and were agitated for one hour at the speed of 200 rpm. With this process, the liquid composition (coating liquid for forming coating film) composed as shown in Table 1 was obtained. Contents (weight %) of the silicon compounds shown in Table 1 were measured by converting from the quantities of residual solid materials obtained by drying a portion of the liquid compositions at 150 °C.

5 ml of the coating liquid for forming coating film obtained as described above was applied on an 8-inch silicon wafer substrate by means of the spin coat method under the same conditions as those employed in Example 1.
The substrate was placed on a sheet-feed type hot plate and was heated in the nitrogen gas atmosphere for 3 minutes at the temperature of 150 °C. In the heating process, the organic solvents included in the film (PGP and ethanol) are evaporated, so that the vaporized materials were discharged to outside of the system.
Furthermore, in the state where the substrate was placed on the sheet-feed type hot plate, electron beam (miniEB produced by Ushio Inc.) with accelerating voltage of 13KV was irradiated at 500 µC/cm² for 30 minutes at the temperature of 300 °C in the nitrogen gas atmosphere and performed curing. Then, the substrate (Example substrate (4)) was cooled down to a temperature near the room temperature, and was taken out of the system.
A thickness of the silica-based coating film formed on the substrate obtained as described above was about 500 nm (when measured with a spectroscopic Ellipsometer ESVG produced by SOPRA).
Then, like in the case of Example 1, measurement was made for (i) an average pore diameter, (ii) pore distribution, (iii) a film strength, (iv) changes in moisture absorption rate before and after irradiation of oxygen plasma, (v) a specific dielectric constant, and (vi) an amount of leakage current. The results of measurements are shown in Tables 2 and 3.

### Comparative Example 1

100-grams fractions were taken out from the liquid composition prepared in Example 1, and contents of water and silicon compounds in each fraction were adjusted as shown in Table 1 by adding pure ware and/or propylene glycol monopropyl ether. The mixture was agitated for one hour at the rotational speed of 200 rpm. With the operation above, samples of the liquid composition (coating liquid for forming a coating film) each having the composition as shown in Table 1 were obtained. It is to be noted that a content (weight %) of the silicon compound shown in Table 1 was measured by converting from the quantities of residual solid materials obtained by drying a portion of the liquid composition at the temperature of 150 °C.
5 ml of the coating liquid for forming a coating film was applied on an 8-inch silicon wafer under the same conditions as those employed in Example 1 by the spin coat method. By repeating the operations described above, a plurality of sample substrates each with the coating liquid applied thereon were obtained.
Then, the substrates were placed on a sheet-feed type hot plate, and were subjected to the heat treatment under the same conditions as those employed in Example 1. During this heat treatment, an organic solvent and other materials contained in the coating film were evaporated, so that the vaporized materials were discharged to outside of the system.

Furthermore, in the state where the substrates were placed over the sheet-feed type hot plate, heat treatment was carried out under the same conditions as those employed in Example 1. Then, the substrates (comparative example substrates (1) to (2)) were cooled down to a temperature near the room temperature, and taken out to outside of the system.
A thickness of the silica-based coating film formed on each substrate as described above was about 500 nm (when measured with a Spectroscopic Ellipsometer ESVG produced by SOPRA).
Then, like in Example 1, measurement was made for the following properties of the silica-based coating film formed on each substrate, namely (i) an average pore diameter, (ii) pore distribution, (iii) a film strength, (iv) changes in moisture absorption before and after irradiation of oxygen plasma, (v) a specific dielectric constant, and (vi) an amount of leakage current. The result is shown in Table 2 and Table 3.

As clearly understood from the measurement result shown in Table 3, with the coating liquid for forming a low dielectric constant amorphous silica-based coating film according to the present invention, a low dielectric constant amorphous silica-based coating film having a low specific dielectric constant of 3.0 or below and a low leakage current can be formed. This possibility is conceivably provided from that the coating film obtained has high moisture resistance (hydrophobicity), and also most of pores generated in the coating film are micropores, the diameter of which is smaller than that of mesopores.
As shown in Table 2, in the coating films formed on the example substrates (1) to (4), an average diameter of pores in the coating films are 3 nm or below, a pore volume of micropores each having a diameter of 2 nm or below are 75% or more in percentage to the total pore volume, the maximum pore diameter is 10 nm or below, and an average diameter of mesopores each having a diameter of more than 2 nm is 4 nm or below. Although not shown in Table 2, any pores having a diameter of 10 nm or more were not found in the coating films formed on the example substrates.

Furthermore, the coating film has high film strength of 6.0 GPa as expressed by the Young's modulus and high moisture resistance (hydrophobicity).
In contrast, the coating film formed on the comparative example substrate (1) has a high film strength and high moisture resistance (hydrophobicity) as shown in Table, but a percentage of pore volume of the micropores is slightly lower, and therefore a percentage of pore volume of mesopores is higher proportionately. In the coating film formed on the comparative example substrate (2), since a surface tension of the liquid composition (coating liquid) is high (namely the wettability is low), the coating liquid was repelled on a surface of the substrate, and as a result, pinholes and the like were generated in the coating film, so that a homogeneous coating film could not be formed. Therefore, the amount of leakage current could not be measured accurately.

Furthermore, in the coating films formed on the example substrates (1) to (4), the specific dielectric constant was low (3.0 or below), and the amount of leakage current was 1.8 x 10⁻¹¹ A/cm² or less when a voltage of 0.2 MV/cm was applied, 1.4 x 10⁻¹⁰ A/cm² or less when a voltage of 0.5 MV/cm was applied, 3.6 x 10⁻⁹ A/cm² or less when a voltage of 1.0 MV/cm was applied, and 4.2 x 10⁻⁸ A/cm² or less when a voltage of 2.0 MV/cm was applied.
In contrast, in the coating film formed on the comparative example substrate (1), the specific dielectric constant was low (3.0 or below), but the amount of leakage current was 10 times or more larger as compared to those in the coating films formed on the example substrates. On the other hand, in the coating film formed on the comparative example substrate (2), accurate measurement for an amount of leakage current could not be carried out.

**Table 1**

| Characteristics of Liquid Compositions | | | | | |
|---|---|---|---|---|---|
| Example substrate | Comparative example substrate | Composition of liquid composition after adjustment | | | |
| | | Silicon compound (weight %) | PGP (weight %) | Ethanol (weight %) | Water (weight %) |
| (1) | | 3.0 | 32.0 | 35.0 | 30.0 |
| (2) | | 3.0 | 34.0 | 20.0 | 43.0 |
| (3) | | 3.0 | 32.0 | 15.0 | 50.0 |
| (4) | | 3.0 | 31.0 | 6.0 | 60.0 |
| | (1) | 3.0 | 32.0 | 40.0 | 25.0 |
| | (2) | 3.0 | 30.0 | 2.0 | 65.0 |

**Table 2**

| Physical Properties of Coating Films | | | | | | | | |
|---|---|---|---|---|---|---|---|---|
| Example substrate | Comparative Example substrate | Average pore diameter (nm) | | | Pore volume of pores (%) | | Young's modulus of coating film (GPa) | Changes in moisture absorption |
| | | Micro Pores | Meso pores | All | Micro pores | Meso pores | | |
| (1) | | 1.0 | 3.9 | 2.9 | 75 | 25 | 6.5 | Normal |
| (2) | | 1.1 | 3.9 | 2.8 | 76 | 24 | 8 | Normal |
| (3) | | 0.9 | 3.7 | 2.7 | 77 | 23 | 9 | Normal |
| (4) | | 1.0 | 3.7 | 2.5 | 78 | 22 | 10 | Normal |
| | (1) | 1.2 | 4.0 | 3.0 | 70 | 30 | 6 | Normal |
| | (2) | - | - | - | - | - | - | (Note 1) |

| | | | | | | | | |
|---|---|---|---|---|---|---|---|---|
| (Note 1) Since a surface tension of the liquid composition was high, the coating liquid was repelled on a surface of the substrate, and a desired coating film could not be obtained. | | | | | | | | |

**Table 3**

| Specific Dielectric Constant and an Amount of Leakage current of Coating films | | | | | | | |
|---|---|---|---|---|---|---|---|
| Example substrate | Comp. example substrate | ε | Leakage current amount | | | | Notes |
| | | | 0.2MV/cm applied | 0.5MV/cm applied | 1.0MV/cm applied | 2.0MV/cm applied | |
| (1) | | 2.47 | 1.8x10⁻¹¹ | 1.4x10⁻¹⁰ | 3.2x10⁻⁹ | 4.2x10⁻⁸ | - |
| (2) | | 2.49 | 1.6x10⁻¹¹ | 1.2x10⁻¹¹ | 3.6x10⁻⁹ | 4.1x10⁻⁸ | - |
| (3) | | 2.52 | 1.7x10⁻¹¹ | 1.1x10⁻¹¹ | 2.8x10⁻⁹ | 3.2x10⁻⁸ | - |
| (4) | | 2.54 | 1.1x10⁻¹¹ | 1.2x10⁻¹¹ | 1.3x10⁻⁹ | 1.4x10⁻⁹ | - |
| | (1) | 2.42 | 1.4x10⁻⁹ | 1.4x10⁻⁹ | 3.3x10⁻⁸ | 4.3x10⁻⁷ | - |
| | (2) | - | - | - | - | - | (Note 2) |

| | | | | | | | |
|---|---|---|---|---|---|---|---|
| ε: Specific Dielectric Constant (Note 2) Since a desired coating film could not be formed, accurate measurement for an amount of leakage current could not be performed. | | | | | | | |

## Claims

1. A coating liquid for forming an amorphous silica-based coating film having a low dielectric constant and a low leakage current, the coating liquid comprising:
(a) a silicon compound obtained by hydrolyzing tetraalkyl orthosilicate (TAOS) and alkoxysilane (AS) expressed by the following general formula (I) in the presence of tetraalkyl ammonium hydroxide (TAAOH) and water:
XₙSi(OR)₄₋ₙ (I)
(wherein X denotes a hydrogen atom, a fluorine atom, an alkyl group having 1 to 8 carbon atoms, a fluorine-substituted alkyl group, an aryl group, or a vinyl group; and R denotes a hydrogen atom, an alkyl group having 1 to 8 carbon atoms, an aryl group, or a vinyl group; and n is an integer from 1 to 3),
(b) an organic solvent, and
(c) water
wherein an amount of water contained in the liquid composition is in the range from 30 to 60% by weight.

2. A coating liquid for forming an amorphous silica-based coating film having a low dielectric constant and a low leakage current, the coating liquid comprising:
(a) a silicon compound obtained by hydrolyzing or partially hydrolyzing tetraalkyl orthosilicate (TAOS) in the presence of tetraalkyl ammonium hydroxide (TAAOH) and water, mixing the hydrolyzed or partially hydrolyzed product with alkoxysilane (AS) expressed by the general formula (I) above or a hydrolyzed or partially hydrolyzed product thereof, and hydrolyzing all or a portion of the resultant mixture;
(b) organic solvent; and
(c) water,
wherein an amount of water contained in the liquid composition is in the range from 30 to 60% by weight.

3. The coating liquid for forming an amorphous silica-based coating film having a low dielectric constant according to claim 1 or 2, wherein the tetraalkyl orthosilicate (TAOS) is tetraethyl orthosilicate (TEOS), tetramethyl orthosilicate (TMOS), or a mixture thereof.

4. The coating liquid for forming an amorphous silica-based coating film having a low dielectric constant according to any of claims 1 to 3, wherein the alkoxysilane (AS) is methyl trimethoxysilane (MTMS), methyl triethoxysilane (MTES), or a mixture thereof.

5. The coating liquid for forming an amorphous silica-based coating film having a low dielectric constant according to any of claims 1 to 4, wherein the tetraalkyl ammonium hydroxide (TAAOH) is tetrapropyl ammonium hydroxide (TPAOH), tetrabutyl ammonium hydroxide (TBAOH), or a mixture thereof.

6. The coating liquid for forming an amorphous silica-based coating film having a low dielectric constant according to any of claims 1 to 5, wherein the organic solvent contains an organic solvent selected from the group consisting of propylene glycol monopropyl ether (PGP), propylene glycol monomethyl ether (PGME), and propylene glycol monomethyl ether acetate (PGMEA).

7. The coating liquid for forming an amorphous silica-based coating film having a low dielectric constant according to any of claims 1 to 6, wherein a content of the silicon compound in the liquid composition is in the range from 2 to 20% by weight.

8. A method for preparing a coating liquid for forming an amorphous silica-based coating film having a low dielectric constant and a low leakage current, the method comprising the steps of:
(a) preparing a liquid composition containing a silicon compound obtained by hydrolyzing tetraalkyl orthosilicate (TAOS) and alkoxysilane (AS) expressed by the following general formula (I), which are contained in an organic solvent, in the presence of tetraalkyl ammonium hydroxide (TAAOH) and water,
XₙSi(OR)₄₋ₙ (I)
(wherein X denotes a hydrogen atom, a fluorine atom, an alkyl group having 1 to 8 carbon atoms, a fluorine substituted alkyl group, an aryl group, or a vinyl group; R denotes a hydrogen atom, an alkyl group having 1 to 8 carbon atoms, an aryl group, or a vinyl group; and n is an integer from 1 to 3.);
(b) subjecting at least a portion of the organic solvent contained in the liquid composition obtained in the step (a) to solvent substitution with an organic solvent selected from the group consisting of propylene glycol monopropyl ether (PGP), propylene glycol monomethyl ether (PGME), and propylene glycol monoethyl ether acetate (PGMEA); and
(c) adjusting an amount of a silicon compound contained in the liquid composition obtained in the step (b) and also adjusting an amount of water to that in the range of 30 to 60% by weight.

9. A method for preparing a coating liquid for forming an amorphous silica-based coating film having a low dielectric constant and a low leakage current, the method comprising the steps of:
(a) preparing a liquid composition containing a silicon compound by hydrolyzing or partially hydrolyzing tetraalkyl orthosilicate (TAOS) which is contained in an organic solvent in the presence of a tetraalkyl ammonium hydroxide (TAAOH) and water, then mixing the hydrolyzed or partially hydrolyzed product with an alkoxysilane (AS) expressed by the general formula (I) above or a hydrolyzed or partial hydrolyzed product thereof, which is contained in an organic solvent, and further hydrolyzing all or a portion of resulting mixture;
(b) subjecting at least a portion of the organic solvent contained in the liquid composition obtained in the step (a) with an organic solvent selected from the group consisting of propylene glycol monopropyl ether (PGP), propylene glycol monomethyl ether (PGME), and propylene glycol monoethyl ether acetate (PGMEA); and
(c) adjusting an amount of a silicon compound contained in the liquid composition obtained in the step (b) and also adjusting an amount of water to that in the range of 30 to 60% by weight.

10. The method for preparing a coating liquid for forming an amorphous silica-based coating film having a low dielectric constant according to claim 8 or 9, wherein the organic solvent used in the step (a) is alcohols such as methanol, ethanol, or propanol.

11. The method for preparing a coating liquid for forming an amorphous silica-based coating film having a low dielectric constant according to any of claims 8 to 10, wherein the tetraalkyl orthosilicate (TAOS) used in the step (a) is tetraethyl orthosilicate (TEOS), tetramethyl orthosilicate (TMOS), or a mixture thereof.

12. The method for preparing a coating liquid for forming an amorphous silica-based coating film having a low dielectric constant according to any of claims 8 to 11, wherein the alkoxysilane (AS) used in the step (a) is methyl trimethoxysilane (MTMS), methyl triethoxysilane (MTES), or a mixture thereof.

13. The method for preparing a coating liquid for forming an amorphous silica-based coating film having a low dielectric constant according to any of claims 8 to 12, wherein the tetraalkyl ammonium hydroxide (TAAOH) used in the step (a) is tetrapropyl ammonium hydroxide (TPAOH), tetrabutyl ammonium hydroxide (TBAOH), or a mixture thereof.

14. The method for preparing a coating liquid for forming an amorphous silica-based coating film having a low dielectric constant according to any of claims 8 to 13, wherein the solvent substitution in the step (b) is performed by a rotary evaporator.

15. An amorphous silica-based coating film having a low dielectric constant obtained by applying the coating liquid for forming an amorphous silica-based coating film having a low dielectric constant according to any of claims 1 to 7 on a substrate, then heat-treating the substrate at a temperature from 80 to 350 °C, and further curing the substrate at the temperature from 350 to 450 °C.

16. An amorphous silica-based coating film having a low dielectric constant obtained by applying the coating liquid for forming an amorphous silica-based coating film having a low dielectric constant according to any of claims 1 to 7 on a substrate, then heating the substrate at a temperature of 80 to 350 °C, and further irradiating an electron beam to the substrate for curing.

17. The amorphous silica-based coating film having a low dielectric constant according to claim 15 or 16, wherein an average diameter of pores contained in the coating film is 3 nm or below and the pore volume of micropores each having a diameter of 2 nm or below is 75% or more in percentage to the total pore volume.

18. The amorphous silica-based coating film having a low dielectric constant according to any of claims 15 to 17, wherein a maximum diameter of pores contained in the coating film is 10 nm or below and an average diameter of mesopores each having a diameter of more than 2 nm is 4 nm or below.

19. The amorphous silica-based coating film having a low dielectric constant according to any of claims 15 to 18, wherein a dielectric constant of the coating film is 3.0 or below and a leakage current is not more than 1.4x10⁻¹⁰ A/cM² when measured as a current density by applying a voltage of 0.5 MV/cm to the coating film.

20. The amorphous silica-based coating film having a low dielectric constant according to any of claims 15 to 19, wherein a Young's modulus of the coating film is 6.0 GPa or more.

21. The amorphous silica-based coating film having a low dielectric constant according to any of claims 15 to 20, wherein the coating film is an interlayer insulating film formed on a semiconductor substrate.
